# FASCICULE DE BREVET EUROPEEN

(11) **EP 4 012 924 B1**
(45) Date de publication et mention de la délivrance du brevet: **03.12.2025**
(21) Numéro de dépôt: 21199140.1
(22) Date de dépôt: 27.09.2021
(51) Int. Cl.: H03F 1/02, H03K 5/24, H03M 1/12

(54) **COMPARATEUR DYNAMIQUE**
DYNAMISCHER KOMPARATOR
DYNAMIC COMPARATOR

(30) Priorité: 09.12.2020 FR 2012890
(43) Date de publication de la demande: 15.06.2022
(73) Titulaire: Commissariat à l'Energie Atomique et aux Energies Alternatives, 75015 Paris (FR)
(72) Inventeur: VERDANT, Arnaud, 38054 Grenoble Cedex 9 (FR)
(74) Mandataire: Cabinet Beaumont

(56) Documents cités:
- SHIM MINSEOB ET AL: "Edge-Pursuit Comparator: An Energy-Scalable Oscillator Collapse-Based Comparator With Application in a 74.1 dB SNDR and 20 kS/s 15 b SAR ADC", IEEE JOURNAL OF SOLID-STATE CIRCUITS, IEEE, USA, vol. 52, no. 4, 1 April 2017 (2017-04-01), pages 1077 - 1090, XP011644063, ISSN: 0018-9200, [retrieved on 20170329], DOI: 10.1109/JSSC.2016.2631299
- NAYAK RAJENDRA ET AL: "Low power ring oscillator for IoT applications", ANALOG INTEGRATED CIRCUITS AND SIGNAL PROCESSING, SPRINGER NEW YORK LLC, US, vol. 93, no. 2, 30 June 2017 (2017-06-30), pages 257 - 263, XP036334426, ISSN: 0925-1030, [retrieved on 20170630], DOI: 10.1007/S10470-017-1015-2

## Description

### Domaine technique

La présente description concerne de façon générale les circuits électroniques, et plus particulièrement les comparateurs dynamiques qui peuvent être prévus dans de tels circuits électroniques.

### Technique antérieure

Les comparateurs dynamiques ont pour rôle d'effectuer la comparaison de deux signaux, de manière synchronisée avec un signal, typiquement un signal d'horloge, et de produire un signal binaire dont l'état binaire indique le résultat de cette comparaison.

Des comparateurs dynamiques sont par exemple utilisés dans des convertisseurs analogiques-numériques à approximations successives. Dans un tel convertisseur, le comparateur dynamique produit, de manière synchrone, un signal de sortie représentatif de la comparaison d'un signal analogique à une tension de seuil de quantification. Cela permet de quantifier le résidu du signal analogique qui est numérisé par le convertisseur, à chaque étape de la recherche par dichotomie du code numérique associé au signal analogique.

A titre d'exemple, un convertisseur analogique-numérique à approximations successives comprend un noeud de distribution de charges auquel sont connectées des premières électrodes d'une pluralité de capacités de valeurs croissantes. Le noeud est chargé avec le signal analogique à numériser alors qu'une tension basse donnée, typiquement une tension nulle, est appliquée sur les deuxièmes électrodes des capacités. Puis, une tension haute est appliquée sur la deuxième électrode de la capacité de plus forte valeur et la tension sur le noeud de distribution de charge est comparée, par un comparateur dynamique, avec une tension de quantification. Si la tension du noeud de distribution de charges est supérieure à la tension de quantification, la deuxième électrode qui était polarisée par la tension haute est repolarisée à la tension basse, sinon la tension haute est maintenue. Puis, ces opérations sont répétées de la capacité la plus forte à la capacité la plus faible, jusqu'à obtenir le code numérique associé au signal analogique à numériser, à partir des polarisations hautes ou basses appliquées sur chacune des deuxièmes électrodes des capacités.

Parmi les comparateurs dynamiques, les comparateurs dynamiques à verrouillage ("dynamic latched comparator" en anglais) sont connus. Un comparateur dynamique à verrouillage, par exemple le comparateur dynamique à verrouillage illustré sur la page internet wikipedia anglaise relative aux comparateurs, comprend typiquement deux inverseurs en contre réaction dont les sorties sont initialisées à un niveau haut lors d'une phase préliminaire, et une paire différentielle reliant les inverseurs à la masse, les deux transistors d'entrée de la paire différentielle recevant les deux signaux à comparer. Ainsi, le signal de plus forte valeur reçu par les transistors d'entrée de la paire différentielle induit un courant plus important dans l'inverseur correspondant, ce qui entraine un basculement plus rapide de la sortie de cet inverseur au niveau bas, et le maintien au niveau haut de la sortie de l'autre inverseur.

Toutefois, dans un comparateur dynamique à verrouillage, les dispersions de fabrication entre les transistors, en particulier entre les transistors d'entrée de la paire différentielle, conduisent à des erreurs de comparaison, donc à des erreurs de quantification lorsque le comparateur est mis en œuvre dans un convertisseur analogique-numérique à approximations successives. De plus, la capacité grille-drain de chacun des transistors d'entrée de la paire différentielle induit un appel de charges sur l'entrée du comparateur, qui dépend du basculement de l'inverseur du comparateur associé à ce transistor. Cet appel de charges, couramment appelé effet de rebond ("kick-back effect" en langue anglaise), pénalise la précision du comparateur, donc de la quantification d'un signal analogique lorsque le comparateur est mis en œuvre dans un convertisseur analogique-numérique à approximations successives.

Parmi les comparateurs dynamiques, les comparateurs dynamiques de type à poursuite de front ("edge pursuit" en anglais) sont également connus.

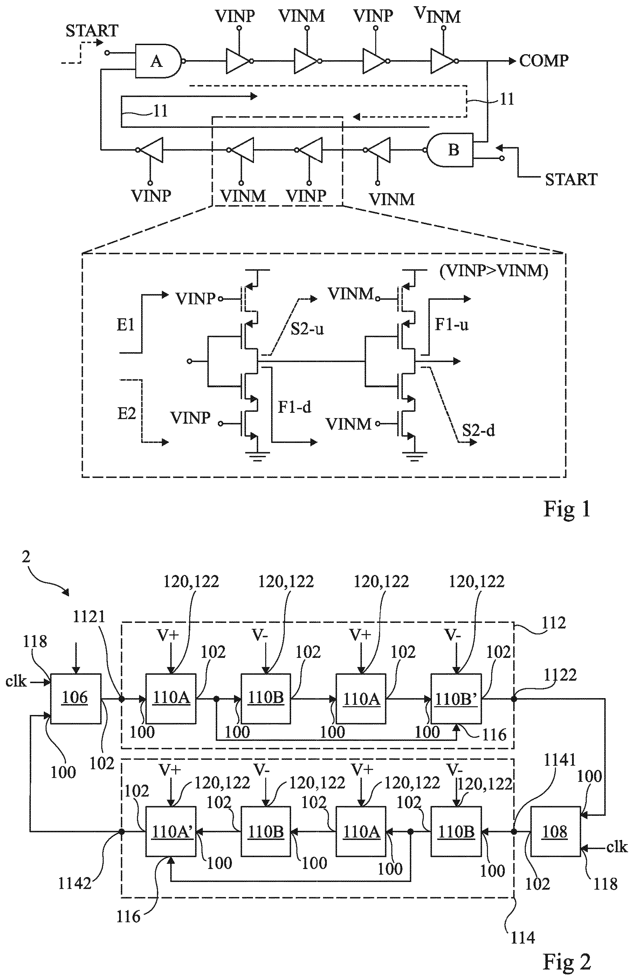

La figure 1 représente un exemple d'un comparateur dynamique de type à poursuite de front. Plus particulièrement, la figure 1 correspond à la figure 2 de l'article de M. Shim et al. intitulé "Edge-Pursuit Comparator: An Energy-Scalable Oscillator Collapse-Based Comparator With Application in a 74.1 dB SNDR and 20 kS/s 15 b SAR ADC" et publié dans IEEE Journal of Solid-State Circuits, Vol. 52, No. 4, Avril 2017.

L'article de NAYAK RAJENDRA ET AL: "Low power ring oscillator for IoT applications",ANALOG INTEGRATED CIRCUITS AND SIGNAL PROCESSING, SPRINGER NEW YORK LLC, US, vol. 93, no. 2, 30 juin 2017, propose un oscillateur en anneau avec doté d'une topologie combinant la temporisation à décalage négatif et la limitation du courant.

Le comparateur de la figure 1 repose sur une structure élémentaire inverseuse composée d'un inverseur CMOS (Métal Oxyde Semiconducteur Complémentaire - "Complementary Metal Oxide Semiconductor" en langue anglaise) standard polarisé par un premier transistor MOS à canal N connecté entre la source du transistor MOS à canal N de l'inverseur et un potentiel de référence, et par un deuxième transistor MOS à canal P connecté entre la source du transistor MOS à canal P de l'inverseur et un potentiel d'alimentation. Les grilles de ces premier et deuxième transistors reçoivent une même tension de polarisation, choisie parmi deux tensions VINP et VINM comparées par le comparateur. En cascadant deux de ces structures élémentaires et en alternant la tension de polarisation VINP ou VINM des structures élémentaires cascadées, par exemple de sorte que la structure élémentaire en amont soit polarisée par la tension VINP et que la structure élémentaire en aval soit polarisée par la tension VINM, on constate les quatre cas suivants :
- front d'entrée montant ("E1" en figure 1) sur la structure élémentaire amont et VINP supérieure à VINM ("VINP > VINM" en figure 1) : descente rapide ("F1-d" en figure 1) de la sortie de la structure élémentaire amont et montée rapide ("F1-u" en figure 1) de la sortie de la structure élémentaire aval,
- front d'entrée montant sur la structure élémentaire amont et VINP inférieure à VINM : descente lente de la sortie de la structure élémentaire amont et montée lente de sortie de la structure élémentaire aval,
- front d'entrée descendant ("E2" en figure 1) sur la structure élémentaire amont et VINP supérieure à VINM ("VINP > VINM" en figure 1) : montée lente ("S2-u" en figure 1) de la sortie de la structure élémentaire amont et descente lente ("S2-d" en figure 1) de la sortie de la structure élémentaire aval, et
- front d'entrée descendant sur la structure élémentaire amont et VINP inférieure à VINM : montée rapide de la sortie de la structure élémentaire amont et descente rapide de la sortie de la structure élémentaire aval.

Le comparateur de la figure 1 comprend deux branches, comprenant chacune quatre structures élémentaires. Les deux branches sont rebouclées l'une sur l'autre par deux portes A et B de type NON-ET ("NAND" en langue anglaise), de manière à former une structure en anneau. Dans l'une des branches (la branche du haut en figure 1), les structures élémentaires sont alternativement polarisées par les tensions VINP puis VINM, alors que c'est l'inverse dans l'autre branche (la branche du bas en figure 1). En outre, l'entrée de chaque porte NON-ET qui n'est pas connecté à la sortie d'une branche reçoit un signal de synchronisation START.

Le fonctionnement de ce comparateur est le suivant. A l'état initial, le signal START est à l'état bas, d'où il résulte que la sortie de chaque porte A et B est à l'état haut et que la sortie de chaque branche, dont la sortie COMP du comparateur, sont à l'état haut également. Le passage à l'état haut du signal START, c'est-à-dire un front montant sur le signal START, provoque le passage à l'état bas de la sortie de chaque porte A et B, c'est-à-dire qu'un front descendant est fourni à la structure en anneau du comparateur par chacune des portes A et B. Ces deux fronts vont se propager à des vitesses différentes dans l'anneau, qui dépendent des tensions de polarisation VINP et VINM. Les deux fronts se propagent alors dans l'anneau (flèches 11 en figure 1) du comparateur jusqu'à ce que le front rapide rejoigne, ou rattrape, le front lent, ce qui résulte en une stabilisation des sorties des structures élémentaires des deux branches, des sorties des portes A et B, et de la sortie COMP du comparateur. Par exemple, dans la configuration de la figure 1, la sortie COMP se stabilise au niveau haut lorsque la tension VINP est supérieure à la tension VINM, et au niveau bas lorsque la tension VINP est inférieure à la tension VINM.

Dans un comparateur de type à poursuite de front, la séquence de transitions sur les deux branches tend à moyenner l'effet de rebond. Cela permet de diminuer l'influence négative de cet effet de rebond par rapport au cas d'un comparateur dynamique à verrouillage. De manière similaire, les erreurs de comparaison induites par les dispersions de fabrication, ainsi que le bruit temporel, sont réduits par rapport à un comparateur dynamique à verrouillage. Plus exactement, plus le nombre de structures élémentaires par branche augmente, plus ces erreurs de comparaison et ce bruit temporel sont lissés.

Toutefois, un inconvénient du comparateur de la figure 1 est que le temps de stabilisation de son anneau, donc de sa sortie COMP, augmente avec la diminution de l'écart entre les tensions VINP et VINM qui sont comparées. L'augmentation du temps de stabilisation n'est pas souhaitable, notamment car elle induit une augmentation de la consommation.

### Résumé de l'invention

Il existe un besoin de pallier tout ou partie des inconvénients des comparateurs dynamiques connus.

Par exemple, il existe un besoin de pallier tout ou partie des inconvénients des comparateurs dynamiques connus de type à poursuite de front.

Un mode de réalisation pallie tout ou partie des inconvénients des comparateurs dynamiques connus.

Par exemple, un mode de réalisation pallie tout ou partie des inconvénients des comparateurs dynamiques connus de type à poursuite de front.

Un mode de réalisation prévoit un comparateur dynamique d'une première tension et d'une deuxième tension, de type à poursuite de front, comprenant un anneau de portes logiques en série, dans lequel :
chaque porte de l'anneau comprend une première entrée connectée à une sortie de la porte précédente de l'anneau ;
chaque porte de l'anneau est configurée pour mettre en œuvre une fonction inverseuse entre sa première entrée et sa sortie ;
au moins une desdites portes de l'anneau est commandable et est associée à une autre desdites portes de l'anneau ;
chaque porte commandable comprend une entrée de commande reliée à la sortie de la porte associée à ladite porte commandable ;
chaque porte commandable est configurée pour empêcher une commutation de sa sortie à un état haut lorsque son entrée de commande est à l'état haut, et à un état bas lorsque son entrée de commande est à l'état bas ;
l'entrée de commande de chaque porte commandable est configurée pour recevoir l'état de la sortie de la porte associée à ladite porte commandable si un nombre pair de portes de l'anneau sépare la porte commandable de ladite porte associée, et pour recevoir l'état complémentaire de ladite sortie sinon ; et
les portes logiques de l'anneau sont en nombre pair.

Selon un mode de réalisation, chaque porte commandable est séparée de la porte associée à la porte commandable par au moins une desdites portes de l'anneau.

Selon un mode de réalisation, un nombre de portes de l'anneau séparant chaque porte commandable de la porte associée à ladite porte commandable est strictement inférieur à la moitié du nombre total de portes de l'anneau moins un.

Selon un mode de réalisation :
lesdites portes de l'anneau comprennent une première porte logique, une deuxième porte logique et des troisièmes et quatrièmes portes logiques ;
une première branche de l'anneau comprend une alternance de troisièmes et quatrièmes portes en série entre la sortie de la première porte et la première entrée de la deuxième porte, la première branche débutant par une troisième porte ;
une deuxième branche de l'anneau comprend une alternance de troisièmes et quatrièmes portes en série entre la sortie de la deuxième porte et la première entrée de la première porte, la deuxième branche débutant par une quatrième porte ; et
chacune des troisièmes et quatrièmes portes est polarisée à partir de la première tension et/ou de la deuxième tension, la polarisation des troisièmes portes étant complémentaire de celle des quatrièmes portes, la polarisation de chacune des troisièmes et quatrièmes portes déterminant une vitesse de commutation de la sortie de ladite porte à l'état haut et une vitesse de commutation de la sortie de ladite porte à l'état bas.

Selon un mode de réalisation, chaque branche comporte un même nombre de troisièmes portes et chaque branche comporte un même nombre de quatrièmes portes.

Selon un mode de réalisation :
chacune des troisièmes et quatrièmes portes comprend un premier noeud de polarisation et un deuxième noeud de polarisation, par exemple confondu avec le premier noeud, une tension sur le premier noeud déterminant la vitesse de commutation de la sortie de ladite porte à l'état haut et une tension sur le deuxième noeud déterminant la vitesse de commutation de la sortie de ladite porte à l'état bas ;
les premiers noeuds des troisièmes portes sont configurés pour recevoir la première tension ou la deuxième tension, les premiers noeuds des quatrièmes portes étant configurés pour recevoir la deuxième tension quand les premiers noeuds des troisièmes portes reçoivent la première tension, ou la première tension quand les premiers noeuds des troisièmes portes reçoivent la deuxième tension ; et
les deuxièmes noeuds des troisièmes portes sont configurés pour recevoir la première tension ou la deuxième tension, les deuxièmes noeuds des quatrièmes portes étant configurés pour recevoir la deuxième tension quand les deuxièmes noeuds des troisièmes portes reçoivent la première tension, ou la première tension quand les deuxièmes noeuds des troisièmes portes reçoivent la deuxième tension.

Selon un mode de réalisation, chaque porte commandable comprend un premier transistor MOS reliant la sortie de la porte commandable à un noeud d'application d'un potentiel haut, le premier transistor ayant une grille connectée à l'entrée de commande de la porte commandable et étant configuré, à l'état bloqué, pour isoler électriquement la sortie de la porte commandable du noeud d'application du potentiel haut. La porte commandable comprend en outre un deuxième transistor MOS reliant la sortie de la porte à un noeud d'application d'un potentiel bas, le deuxième transistor ayant une grille connectée à l'entrée de commande de la porte commandable et étant configuré, à l'état bloqué, pour isoler électriquement la sortie de la porte commandable du noeud d'application du potentiel bas.

Selon un mode de réalisation, chacune des troisièmes et quatrièmes portes comprend :
au moins un premier transistor MOS configuré pour commuter la sortie de ladite porte à l'état haut lorsque la première entrée de ladite porte reçoit un front descendant, ledit au moins un premier transistor étant polarisé à partir de la tension sur le premier noeud de ladite porte ; et
au moins un deuxième transistor MOS configuré pour commuter la sortie de ladite porte à l'état bas lorsque la première entrée de ladite porte reçoit un front montant, ledit au moins un deuxième transistor étant polarisé à partir de la tension sur le deuxième noeud de ladite porte.

Selon un mode de réalisation, chacune des troisièmes et quatrièmes portes comprend un unique premier transistor et un unique deuxième transistor.

Selon un mode de réalisation, dans chacune des troisièmes et quatrièmes portes :
ledit au moins un premier transistor est en série avec un transistor ayant une grille connectée au premier noeud de ladite porte et ledit au moins un deuxième transistor est en série avec un autre transistor ayant une grille connectée au deuxième noeud de ladite porte ; ou
ledit au moins un premier transistor et ledit au moins un deuxième transistor sont mis en œuvre sur silicium sur isolant, par exemple complétement déplété, une grille arrière de chaque premier transistor étant connectée au premier noeud de ladite porte et une grille arrière de chaque deuxième transistor étant connectée au deuxième noeud de ladite porte.

Selon un mode de réalisation, chaque porte commandable est l'une des troisièmes et quatrièmes portes et comprend en outre un troisième transistor MOS configuré, à l'état bloqué, pour isoler électriquement la sortie de ladite porte commandable d'un noeud d'application d'une tension d'alimentation, et un quatrième transistor MOS configuré, à l'état bloqué, pour isoler électriquement la sortie ladite porte commandable d'un noeud d'application d'une tension de référence, une grille de chacun des troisième et quatrième transistors étant connectée à l'entrée de commande de ladite porte commandable.

Selon un mode de réalisation, les première et deuxième branches sont symétriques.

Selon un mode de réalisation, chacune des première et deuxième portes comprend en outre une deuxième entrée configurée pour recevoir un signal de synchronisation, la mise en œuvre de la fonction inverseuse entre la première entrée et la sortie de ladite porte étant conditionnée par l'état du signal de synchronisation.

Selon un mode de réalisation, pour chaque porte commandable, la porte associée à ladite porte commandable est la première porte ou l'une des troisièmes et quatrièmes portes de la première branche lorsque ladite porte commandable appartient à la première branche, et est la deuxième porte ou l'une des troisièmes et quatrièmes portes de la deuxième branche lorsque ladite porte commandable appartient à la deuxième branche.

Un mode de réalisation prévoit un convertisseur analogique-numérique comprenant un comparateur tel que décrit.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente un exemple d'un comparateur dynamique de type à poursuite de front ;
la figure 2 représente, de manière schématique et sous la forme de blocs, un mode de réalisation d'un comparateur dynamique de type à poursuite de front ;
la figure 3 représente, de manière schématique, un mode de réalisation d'une porte du comparateur dynamique de la figure 2 ;
la figure 4 représente, de manière schématique, une variante de réalisation d'une porte du comparateur dynamique de la figure 2 ; et
la figure 5 représente, de manière schématique, un mode de réalisation d'une autre porte du comparateur dynamique de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits électroniques usuels dans lesquels un comparateur dynamique est mis en œuvre n'ont pas été détaillés, les modes de réalisation décrits étant compatibles avec ces circuits usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Dans la suite de la description, dans un anneau d'un comparateur dynamique de type à poursuite de front, on considère qu'une première porte logique de l'anneau précède, ou est en amont, d'une deuxième porte logique de l'anneau, lorsqu'un front se propageant dans l'anneau est d'abord propagé par, ou à travers, la première porte puis par, ou à travers, la deuxième porte. A l'inverse, on considère en outre qu'une première porte logique de l'anneau suit, ou est en aval, d'une deuxième porte logique de l'anneau lorsqu'un front se propageant dans l'anneau est d'abord propagé par, ou à travers, la deuxième porte puis par, ou à travers, la première porte. Dit autrement, les termes "amont", "aval", "précédente" et "suivante" appliqués à des portes de l'anneau sont définis par rapport au sens de propagation des fronts dans l'anneau.

Dans la suite de la description, un front, ou une transition binaire, peut avoir deux sens différents, à savoir le sens montant et le sens descendant. Un front de sens montant, respectivement descendant, sera plus généralement appelé front montant, respectivement front descendant.

Dans la suite de la description, on appelle porte logique une porte, ou un circuit, purement combinatoire, c'est-à-dire dépourvue de fonction de mémorisation. De préférence, les portes logiques décrites ici sont mises en œuvre en technologie CMOS (de l'anglais "Complementary Metal Oxide Semiconductor" - Métal Oxyde Semiconducteur Complémentaire).

La présente demande propose un comparateur dynamique de type à poursuite de front, dans lequel au moins une des portes logiques des branches de l'anneau du comparateur est commandée par une sortie d'une porte amont, ou précédente, de l'anneau, et est configurée pour bloquer la propagation du front le plus lent lorsque la sortie de cette porte amont commute suite à la propagation du front le plus rapide. Du fait que la porte amont et la porte commandée par la sortie de la porte amont sont séparées l'une de l'autre par au moins une autre porte logique de l'anneau, cela permet de réduire le temps de stabilisation de l'anneau, et donc de réduire la consommation du comparateur.

La figure 2 représente, de manière schématique et sous la forme de blocs, un mode de réalisation d'un tel comparateur 2. Le comparateur 2 est configuré pour comparer une tension V+ avec une tension V-.

Le comparateur 2 comprend un anneau. L'anneau comporte plusieurs portes logiques en série. Plus particulièrement, chaque porte de l'anneau comprend une entrée 100 connectée à une sortie 102 de la porte précédente de l'anneau. Chaque porte de l'anneau est configurée pour mettre en œuvre une fonction inverseuse entre son entrée 100 et sa sortie 102.

Selon un mode de réalisation, les portes de l'anneau comprennent une porte logique 106, une porte logique 108, des portes logiques 110A et des portes logiques 110B. L'anneau comprend une branche 112 (délimitée par des traits en pointillé en figure 2) et une branche 114 (délimitée par des traits en pointillé en figure 2). Les branches 112 et 114 sont rebouclées l'une sur l'autre par les portes 106 et 108.

Selon ce mode de réalisation, la branche 112 comprend une alternance de portes 110A et 110B entre son entrée 1121 et sa sortie 1122. La branche 112 débute par une porte 110A, ou, dit autrement, l'entrée 1121 de la branche 112 correspond à l'entrée 100 d'une porte 110A. En outre, la branche 114 comprend une alternance de portes 110A et 110B entre son entrée 1141 et sa sortie 1142. La branche 114 débute par une porte 110B, ou, dit autrement, l'entrée 1141 de la branche 114 correspond à l'entrée 100 d'une porte 110B. Chaque porte 110A, 110B est polarisée à partir de la tension V+ et/ou de la tension V-. La polarisation, à partir de l'une et/ou l'autre des tensions V+ et V-, de chaque porte 110A, 110B détermine une vitesse de commutation de la sortie 102 de la porte à l'état haut et une vitesse de commutation de la sortie 102 de la porte à l'état bas. Plus particulièrement, chaque porte 110A est polarisée, à partir de l'une et/ou l'autre des tensions V+ et V-, de manière complémentaire à la façon dont est polarisée chaque porte 110B à partir de l'une et/ou l'autre de ces tensions V+ et V-. Ainsi, lorsque les tensions V+ et V- sont différentes, les vitesses de commutation à l'état bas, respectivement haut, des portes 110A sont différentes des vitesses de commutation à l'état bas, respectivement haut, des portes 110B.

Selon un mode de réalisation, chaque porte 110A, 110B comprend un noeud de polarisation 120 et un noeud de polarisation 122. Une vitesse de commutation à l'état haut de la sortie 102 de chaque porte 110A, 110B est déterminée par une tension sur le noeud 120 de la porte considérée, une vitesse de commutation à l'état bas de la sortie 102 de chaque porte 110A, 110B étant déterminée par une tension sur le noeud 122 de la porte considérée. La polarisation complémentaire entre les portes 110A et 110B est alors mise en œuvre de la façon suivante. Les noeuds 120 des portes 110A sont configurés pour recevoir la tension V+ ou V-, et les noeuds 120 des portes 110B sont configurés pour recevoir la tension V+ quand les noeuds 120 des portes 110A reçoivent la tension V-, ou pour recevoir la tension V- quand les noeuds 120 des portes 110A reçoivent la tension V+. En outre, les noeuds 122 des portes 110A sont configurés pour recevoir la tension V+ ou V-, et les noeuds 122 des portes 110B sont configurés pour recevoir la tension V+ quand les noeuds 122 des portes 110A reçoivent la tension V-, ou pour recevoir la tension V- quand les noeuds 122 des portes 110A reçoivent la tension V+.

Dans le mode de réalisation de la figure 2, les noeuds 120 et 122 de chaque porte 110A reçoivent la même tension V+, les noeuds 120, 122 de chaque porte 110B recevant la même tension V-. Dans ce cas, comme cela est représenté en figure 2, les noeuds 120 et 122 peuvent être confondus. Dans une variante de réalisation non illustrée, le noeud 120 de chaque porte 110A reçoit la tension V+, le noeud 120 de chaque porte 110B reçoit la tension V-, le noeud 122 de chaque porte 110A reçoit la tension V- et le noeud 122 de chaque porte 110B reçoit la tension V+. Toutefois, le mode de réalisation où chaque porte reçoit la même tension sur ses deux noeuds 120 et 122 est préféré car il permet que le comparateur 2 se stabilise plus rapidement pour un écart donné entre les tensions V+ et V-.

Selon un mode de réalisation, la branche 112 comprend autant de portes 110A que la branche 114, et autant de portes 110B que la branche 114. De préférence, chaque branche 112, 114 de l'anneau comprend un même nombre pair de portes 110A, 110B.

L'anneau comprend un nombre pair de portes logiques 110A, 110B, 106 et 108. Du fait de la fonction inverseuse mise en œuvre par chaque porte 110A, 110B, 106 et 108, entre son entrée 100 et sa sortie 102, lorsque des fronts se propagent dans l'anneau, l'anneau se stabilise lorsque le front le plus rapide rattrape le front le plus lent.

Une sortie OUT du comparateur 2 est disponible sur la sortie 1122 de la branche 112 ou sur la sortie 1142 de la branche 114.

Parmi les portes 106, 108, 110A, 110B, de préférence parmi les portes 110A et 110B de l'anneau, une ou plusieurs portes sont commandables. Dans l'exemple de la figure 2, la branche 112 de l'anneau comprend une porte 110B commandable, référencée 110B' dans la suite de la description, et la branche 114 de l'anneau comprend une porte 110A commandable, référencée 110A' dans la suite de la description. Plus particulièrement, dans l'exemple de la figure 2, la porte 110B' de la branche 112 est la dernière porte de la branche, ou, dit autrement, la sortie de la porte 110B' de la branche 112 correspond à la sortie 1122 de la branche 112, et la porte 110A' de la branche 114 est la dernière porte de la branche, ou, dit autrement, la sortie de la porte 110A' de la branche 114 correspond à la sortie 1142 de la branche 114. Toutefois, les modes de réalisation décrits ne se limitent pas à cet exemple. Par exemple, l'une des branches 112, 114 ou chacune des branches 112 et 114 peut comprendre plus d'une porte commandable, ou l'une des deux branches 112, 114 peut être dépourvue de porte commandable. En outre, le nombre et/ou la position des portes commandables de la branche 112 peuvent être différents du nombre et/ou de la position des portes commandables de la branche 114. Cependant, dans des modes de réalisation préférés, lorsqu'une porte commandable est disposée à une position donnée de la branche 112, et est séparée de la porte associée qui la commande par un nombre donné de portes, la branche 114 comprend une porte commandable à la même position dans la branche 114, cette porte commandable de la branche 114 étant séparée de la porte associée qui la commande par le même nombre donné de portes. Cela permet d'obtenir un comparateur dans lequel le temps de stabilisation, ou de réponse, du comparateur est sensiblement le même lorsque la tension V+ est supérieure à la tension V-, avec un écart donné entre les tensions V+ et V-, et lorsque la tension V+ est inférieure à la tension V-, avec le même écart donné entre ces tensions V+ et V-.

Dans la suite de la description, sauf indication contraire, l'expression "les portes 110A", respectivement, "les portes 110B", désigne toutes les portes 110A, respectivement 110B, de l'anneau, y compris les éventuelles portes commandables 110A', respectivement 110B'. En outre, bien que cela ne soit pas illustré ici, chaque porte 106 et 108 peut être une porte commandable telle que décrite ci-dessus.

Chaque porte commandable de l'anneau est associée à une autre porte de l'anneau, de préférence disposée en amont de la porte commandable dans l'anneau. Plus particulièrement, chaque porte commandable 110A', 110B' comprend une entrée de commande 116 reliée à la sortie 102 de la porte à laquelle cette porte commandable est associée. Dans l'exemple de la figure 2, l'entrée 116 de la porte commandable 110B' de la branche 112 est reliée à la sortie 102 de la première porte de la branche 112, à savoir ici une porte 110A, l'entrée 116 de la porte commandable 110A' de la branche 114 étant reliée à la sortie 102 de la première porte de la branche 114, à savoir ici une porte 110B. Toutefois, les modes de réalisation décrits ne se limitent pas à cet exemple, et une porte commandable d'une branche peut être associée à une porte qui n'est pas la première porte de cette branche. En outre, une porte commandable 110A', 110B' peut être associée à, ou commandée par, une porte 106 ou 108.

Selon un mode de réalisation, chaque porte commandable 110A', 110B' est séparée de la porte associée à cette porte commandable par une ou plusieurs autres portes de l'anneau.

Selon un mode de réalisation, le nombre de portes séparant chaque porte commandable 110A', 110B' de la porte à laquelle est associée cette porte commandable est inférieur strictement à la moitié du nombre total de portes de l'anneau minorée d'une unité. Dans l'exemple de la figure 2 où chaque branche 112, 114 comprend deux portes 110A et deux portes 110B, et où le nombre total de portes de l'anneau est égal à dix, au maximum trois portes de l'anneau séparent chaque porte commandable 110A', 110B' de la porte à laquelle elle est associée. Le nombre de portes séparant une porte commandable 110A', 110B' et la porte qui la commande, c'est-à-dire le nombre de portes disposées entre l'entrée 100 de cette porte commandable 110A', 110B' et la sortie 102 de la porte qui la commande, est compté en suivant le sens de propagation des fronts dans l'anneau, à partir de la sortie 102 de la porte associée à la porte commandable. Ainsi, dans l'exemple de la figure 2, la porte commandable 110B' de la branche 112 est séparée de la porte 110A qui la commande par deux portes, à savoir successivement une porte 110B et une porte 110A en allant de la sortie 102 de la porte 110A qui commande la porte 110B' jusqu'à l'entrée de la porte commandable 110B'. De manière similaire, dans l'exemple de la figure 2, la porte commandable 110A' de la branche 114 est séparée de la porte 110B qui la commande par deux portes, à savoir successivement une porte 110A et une porte 110B en allant de la sortie 102 de la porte 110B qui commande la porte 110A' jusqu'à l'entrée de la porte commandable 110A'.

Selon un mode de réalisation, la porte associée à chaque porte commandable de la branche 112, respectivement 114, appartient à cette branche 112, respectivement 114, ou correspond à la porte 106, respectivement 108.

Selon un mode de réalisation, les branches 112 et 114 sont symétriques. Dit autrement, pour chaque position dans la branche 112, la porte qui est à cette position est identique à la porte qui est à la même position dans la branche opposée 114, exception faite, le cas échéant, de la tension V+ et/ou de la tension V- reçues sur les noeuds 120 et 122 de ces portes. En particulier, lorsqu'une porte commandable est disposée à une position donnée de la branche 112, et est séparée de la porte associée qui la commande par un nombre donné de portes, la branche 114 comprend, de préférence, une porte commandable à la même position dans la branche 114, cette porte commandable de la branche 114 étant, de préférence, séparée de la porte associée qui la commande par le même nombre donné de portes.

Selon un mode de réalisation, toutes les portes 110A, 110B non commandables sont identiques, exception faite, le cas échéant, de la tension V+ et/ou de la tension V- reçues sur les noeuds 120 et 122 de ces portes, et toutes les portes commandables 110A', 110B' sont identiques, exception faite, le cas échéant, de la tension V+ et/ou de la tension V- reçues sur les noeuds 120 et 122 de ces portes.

Chaque porte commandable 110A', 110B' est configurée pour empêcher une commutation de sa sortie 102 à l'état haut lorsque son entrée 116 est à l'état haut, et pour empêcher une commutation de sa sortie 102 à l'état bas lorsque que son entrée 116 est à l'état bas.

Selon un mode de réalisation, chaque porte commandable 110A', 110B' comprend un premier transistor MOS reliant la sortie 102 de la porte commandable à un noeud d'application d'un potentiel haut, par exemple un potentiel d'alimentation haut, ce premier transistor ayant sa grille connectée à l'entrée de commande 116 de la porte commandable et étant configuré, à l'état bloqué, pour isoler électriquement la sortie 102 de la porte commandable du noeud d'application du potentiel haut. De manière symétrique, chaque porte commandable 110A', 110B' comprend en outre un deuxième transistor MOS reliant la sortie 102 de la porte à un noeud d'application d'un potentiel bas, par exemple un potentiel d'alimentation bas, ce deuxième transistor ayant sa grille connectée à l'entrée de commande 116 de la porte commandable et étant configuré, à l'état bloqué, pour isoler électriquement la sortie 102 de la porte commandable du noeud d'application du potentiel bas. Dit autrement, le premier transistor MOS est configuré, à l'état bloqué, pour empêcher une commutation à l'état haut de la sortie 102 de la porte commandable, ce premier transistor MOS étant configuré pour être bloqué lorsque l'entrée de commande 116 de la porte commandable est à l'état haut, et, de manière symétrique, le deuxième transistor MOS est configuré, à l'état bloqué, pour empêcher une commutation à l'état bas de la sortie 102 de la porte commandable, ce deuxième transistor MOS étant configuré pour être bloqué lorsque l'entrée de commande 116 de la porte commandable est à l'état bas. Un avantage d'un tel mode de réalisation est que, quel que soit l'état de l'entrée de commande 116 et l'état de l'entrée 100 d'une porte commandable, il n'y a pas de conduction croisée ("cross conduction" en anglais) dans la porte commandable. Bien entendu, ce mode de réalisation s'applique lorsque la porte 106 ou 108 est commandable, cette dernière comprenant alors les premier et deuxième transistors décrits ci-dessus, ce qui permet que, quel que soit l'état de l'entrée de commande 116, de l'entrée 100 et de l'entrée 118 de cette porte commandable, il n'y a pas de conduction croisée dans la porte commandable.

L'entrée 116 de chaque porte commandable 110A', 110B' est configurée pour recevoir l'état, haut ou bas, de la sortie 102 de la porte à laquelle est associée cette porte commandable lorsque le nombre de portes de l'anneau séparant la porte commandable et la porte qui lui est associée est pair. Dit autrement, dans ce cas, l'entrée 116 de la porte commandable est connectée à la sortie 102 de la porte qui lui est associée. En outre, l'entrée 116 de chaque porte commandable 110A', 110B' est configurée pour recevoir l'état complémentaire de la sortie 102 de la porte à laquelle est associée cette porte commandable, à savoir l'état haut si la sortie 102 est à l'état bas et l'état bas si la sortie 102 est à l'état haut, lorsque le nombre de portes de l'anneau séparant la porte commandable et la porte qui lui est associée est impair. Dit autrement, dans ce cas, l'entrée 116 de la porte commandable est reliée à la sortie 102 de la porte qui lui est associée par un nombre impair d'inverseurs, de préférence par un unique inverseur. Comme précédemment, le nombre de portes séparant une porte commandable et la porte qui la commande, c'est-à-dire le nombre de portes disposées entre l'entrée 100 de cette porte commandable 110A', 110B' et la sortie 102 de la porte à laquelle la porte commandable est associée, est compté en suivant le sens de propagation des fronts dans l'anneau, à partir de la sortie 102 de la porte associée à la porte commandable.

Dans le comparateur 2, chaque porte 106, 108 comprend une entrée 118 configurée pour recevoir un signal de synchronisation, par exemple un signal d'horloge, clk. Chaque porte 106, 108 est configurée pour que la fonction inverseuse mise en œuvre entre son entrée 100 et sa sortie 102 soit conditionnée par l'état du signal clk de synchronisation. Par exemple, cette fonction inverseuse n'est mise en œuvre que si le signal sur l'entrée 118 de la porte est à un état donné parmi les états haut et bas que peut prendre ce signal.

Par exemple, les portes 106 et 108 sont mises en œuvre chacune par une porte NON-ET ("NAND" en anglais). Dans ce cas, la fonction inverseuse entre l'entrée 100 et la sortie 102 de la porte n'est mise en œuvre que si le signal clk est à l'état haut. En effet, si le signal clk est à l'état bas, la sortie 102 de la porte est nécessairement à l'état haut, quel que soit l'état de l'entrée 100 de la porte.

Selon un autre exemple, les portes 106 et 108 sont mises en œuvre chacune par une porte NON-OU ("NOR" en anglais) . Dans ce cas, la fonction inverseuse entre l'entrée 100 et la sortie 102 de la porte n'est mise en œuvre que si le signal clk est à l'état bas. En effet, si le signal clk est à l'état haut, la sortie 102 de la porte est nécessairement à l'état bas, quel que soit l'état de l'entrée 100 de la porte.

Le fonctionnement du comparateur 2 est le suivant. Dans cet exemple, on considère que les portes 106 et 108 sont mises en œuvre chacune par une porte NON-ET. A un instant initial, le signal clk est à l'état bas, d'où il résulte que la sortie 102 de chaque porte 106 et 108 est à l'état haut et qu'aucun front, ou transition, ne se propage dans l'anneau. La sortie de chaque branche 112, 114 est alors à l'état haut dans l'exemple illustré par la figure 2. A un instant suivant, le signal clk commute à l'état haut, d'où il résulte un front descendant de la sortie 102 de chaque porte 106, 108. Ces deux fronts se propagent alors dans l'anneau, à des vitesses qui dépendent de la différence entre la tension V+ et la tension V-. A un instant suivant, le front qui se propage le plus lentement dans l'anneau est situé entre une porte commandable et la porte associée qui la commande, par exemple entre la première porte 110A de la branche 112 et la porte 110B' de la branche 112. En outre, à cet instant, la porte 110A qui commande la porte commandable 110B' de la branche 112 reçoit le font le plus rapide, et sa sortie commute, par exemple à l'état bas. Dans l'exemple de la figure 2 où un nombre pair de portes séparent la porte 110B' de la porte 100A qui la commande, cela bloque la commutation à l'état bas de la sortie 102 de la porte commandable 110B'. A un instant suivant, le front le plus lent se présente sur l'entrée 100 de la porte commandable 110B' de la branche 112, ce front lent étant un front montant dans l'exemple considéré. Comme l'entrée 116 de la porte commandable 110B' de la branche 112 est à l'état bas, la sortie 102 de cette porte 110B' ne peut pas commuter à l'état bas, et son état, à savoir l'état haut dans l'exemple considéré, ne change pas. Le front lent est alors bloqué sur l'entrée 100 de cette porte commandable 110B'. A un instant suivant, le front le plus rapide se présente sur l'entrée 100 de la porte commandable 110B' de la branche 112, le front rapide étant un front descendant dans l'exemple considéré, et rattrape donc le front lent. Du fait que la sortie 102 de la porte 110B' est déjà à l'état haut, cela ne modifie pas l'état de cette sortie 102. Il en résulte que la propagation des fronts dans l'anneau est stoppée, l'anneau se stabilise et le résultat de la comparaison de la tension V+ avec la tension V- est donné par l'état du signal OUT.

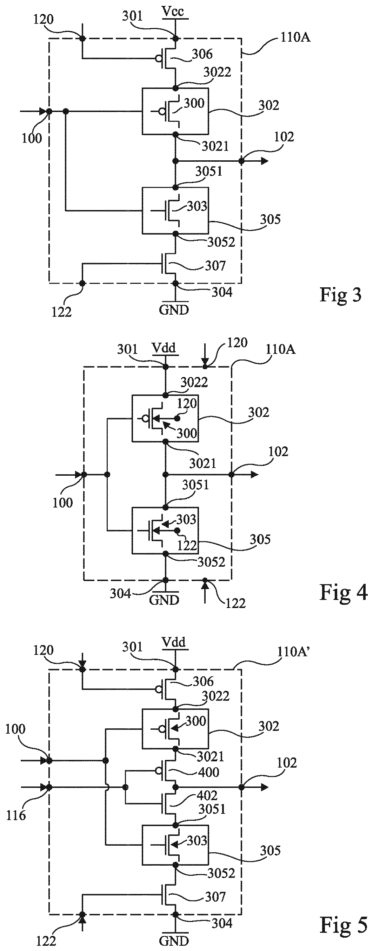

La figure 3 représente, de manière schématique, un mode de réalisation d'une porte 110A non commandable du comparateur 2 de la figure 2. Dans ce mode de réalisation, toutes les portes non commandables 110A et 110B sont par exemple mises en œuvre de la même façon que la porte 110A de la figure 3, en adaptant la ou les tensions reçues par les noeuds 120 et 122 des portes 110B par rapport à celles reçues par les noeuds 120 et 122 des portes 110A.

La porte 110A comprend au moins un transistor MOS 300, de préférence à canal P, reliant la sortie 102 de la porte à un noeud 301 d'application d'un potentiel d'alimentation Vcc. En figure 3, le transistor 300, ou l'ensemble des transistors 300 lorsque la porte comprend plusieurs transistors 300, est représenté schématiquement sous la forme d'un bloc 302. A titre d'exemple, lorsque la porte comprend plusieurs transistors MOS 300, ces transistors sont associés en série et/ou en parallèle entre un noeud 3021 relié, par exemple connecté, à la sortie 102, et un noeud 3022 relié au noeud 301.

La porte 110A comprend en outre au moins un transistor MOS 303, de préférence à canal N, reliant la sortie 102 de la porte à un noeud 304 d'application d'un potentiel de référence, par exemple la masse GND. En figure 3, le transistor 303, ou l'ensemble des transistors 303 lorsque la porte 108 comprend plusieurs transistors 303, est représenté schématiquement sous la forme d'un bloc 305. A titre d'exemple, lorsque la porte 108 comprend plusieurs transistors MOS 303, ces transistors sont associés en série et/ou en parallèle entre un noeud 3051 relié, par exemple connecté, à la sortie 102, et un noeud 3052 relié au noeud 304.

Le ou les transistors 300 sont configurés pour commuter la sortie 102 de la porte 110A à l'état haut (Vcc) lorsque l'entrée 100 de la porte 110A reçoit un front descendant, c'est-à-dire une transition de l'état haut (Vcc) à l'état bas (GND). De manière similaire, le ou les transistors 303 sont configurés pour commuter la sortie 102 de la porte 110A à l'état bas (GND) lorsque l'entrée 100 de la porte 110A reçoit un front montant, c'est-à-dire une transition de l'état bas (GND) à l'état haut (Vcc). Par exemple, chaque transistor 300, 303 a sa grille connectée à l'entrée 100 de la porte.

Le ou les transistors 300 sont polarisés à partir de la tension présente sur le noeud 120 de la porte, d'où il résulte que la vitesse de commutation à l'état haut de la sortie 102 de la porte dépend de cette tension. En outre, le ou les transistors 303 sont polarisés à partir de la tension présente sur le noeud 122 de la porte, d'où il résulte que la vitesse de commutation à l'état bas de la sortie 102 de la porte dépend de cette tension.

Dans le mode de réalisation illustré par la figure 3, la porte 110A comprend en outre un transistor MOS 306, de préférence à canal P, et un transistor MOS 307, de préférence à canal N. Le transistor 306, respectivement 307, est configuré pour mettre en œuvre la polarisation du ou des transistors 300, respectivement 303, à partir de la tension sur le noeud 120, respectivement 122. La grille du transistor 306 est connectée au noeud 120, la grille du transistor 307 étant connectée au noeud 122.

Plus particulièrement, le transistor 306 est en série avec le transistor 300, ou l'ensemble des transistors 300 le cas échéant, entre la sortie 102 et le noeud 301 de la porte, le transistor 307 étant en série avec le transistor 303, ou l'ensemble des transistors 303 le cas échéant, entre la sortie 102 et le noeud 304.

Dans l'exemple de la figure 3 le transistor 306 relie le bloc 302 au noeud 301, et le transistor 307 relie le bloc 305 au noeud 304. Par exemple, le transistor 306 a une borne de conduction, par exemple sa source, reliée, de préférence connectée, au noeud 301, et une autre borne de conduction, par exemple son drain, reliée, de préférence connecté, au noeud 3022. De manière similaire, le transistor 307 a, par exemple, une borne de conduction, par exemple sa source, reliée, de préférence connectée, au noeud 304, et une autre borne de conduction, par exemple son drain, reliée, de préférence connectée, au noeud 3052. Dans un autre exemple non illustré, le transistor 306 relie la sortie 102 de la porte au bloc 302 et/ou le transistor relie la sortie 102 au bloc 305.

Selon un mode de réalisation, la porte 110A comprend un unique transistor 300 et un unique transistor 303. Dans ce cas, une borne de conduction, par exemple la source, du transistor 300 est reliée, de préférence connectée, au noeud 3022, une autre borne de conduction, par exemple le drain, du transistor 300 est reliée, de préférence connectée, au noeud 3021, une borne de conduction, par exemple la source, du transistor 303 est reliée, de préférence connectée, au noeud 3052, et une autre borne de conduction, par exemple le drain, du transistor 303 est reliée, de préférence connectée, au noeud 3051.

Dans une variante de réalisation, la porte 110A comprend plusieurs transistors 300, par exemple deux transistors 300, connectés en parallèle entre les noeuds 3022 et 3021 et/ou plusieurs transistors 303, par exemple deux transistors 303, connectés en série entre les noeuds 3051 et 3052.

A titre d'exemple, les transistors de la porte 110A sont mis en œuvre sur un substrat semiconducteur massif. Selon un autre exemple, les transistors de la porte 110A sont mis en œuvre sur une structure de type semiconducteur sur isolant (SOI de l'anglais "Semicoductor On Insulator") ou de type semiconducteur complétement déplété sur isolant (FDSOI de l'anglais "Fully-Depleted SOI").

La figure 4 représente, de manière schématique, une variante de réalisation de la porte 110A non commandable de la figure 3. Dans cette variante de réalisation, toutes les portes non commandables 110A et 110B sont par exemple mises en œuvre de la même façon que la porte 110A de la figure 4, en adaptant la ou les tensions reçues par les noeuds 120 et 122 des portes 110B par rapport à celles reçues par les noeuds 120 et 122 des portes 110A.

La porte 110A de la figure 4 comprend de nombreux éléments en commun avec la porte 110A de la figure 3, et seules les différences entre ces deux portes sont ici mises en exergue.

Plus particulièrement, la porte 110A de la figure 4 diffère de celle de la figure 3 uniquement par la façon dont le ou les transistors 300 sont polarisés à partir de la tension présente sur le noeud 120 de la porte, et dont le ou les transistors 303 sont polarisés à partir de la tension présente sur le noeud 122 de la porte.

Dans cette variante, les transistors 300 et 303 sont mis en œuvre à partir d'une structure SOI, de préférence à partir d'une structure FDSOI.

Du fait que les transistors 300 et 303 sont mis en œuvre sur SOI ou sur FDSOI, chacun de ces transistors 300 et 303 dispose d'une grille arrière ("back gate" en anglais) en plus de sa grille, dite aussi grille avant ("front gate" en anglais). La grille arrière de chaque transistor 300, respectivement 303, est alors connectée au noeud de polarisation 120, respectivement 122.

Du fait que la tension présente sur la grille arrière des transistors 300 et que la tension présente sur la grille arrière des transistors 303 modifient le seuil de mise en conduction de ces transistors, la vitesse de commutation à l'état haut de la sortie 102 de la porte 110A dépend bien de la tension sur le noeud 120 et la vitesse de commutation à l'état bas de la sortie 102 de la porte 110A dépend bien de la tension sur le noeud 122.

Ainsi, dans cette variante de réalisation, les transistors 306 et 307 décrits en relation avec la figure 3 peuvent être omis, la porte 110A de la figure 4 étant alors plus compacte que la porte 110A décrite en relation avec la figure 3. On pourra toutefois prévoir de combiner la variante de réalisation de la figure 4 et le mode de réalisation de la figure 3, c'est-à-dire prévoir que la porte 110A comprenne les transistors 306 et 307 décrits en relation avec la figure 3 et que les transistors 300 et 303 de cette porte 110A aient leurs grilles arrière connectées aux noeuds 120 et 122 comme cela est décrit en relation avec la figure 4.

Lorsque les transistors 306 et 307 sont omis, comme c'est par exemple le cas en figure 4, le noeud 3022 est, par exemple, connecté au noeud 301, le noeud 3052 étant, par exemple, connecté au noeud 304.

La figure 5 représente, de manière schématique, un mode de réalisation d'une porte 110A' commandable du comparateur 2 de la figure 2. Dans ce mode de réalisation, toutes les portes commandable 110A', 110B' sont mises en œuvre de la même façon que la porte 110A' de la figure 5.

La porte 110A' de la figure 5 comprend de nombreux éléments en commun avec la porte 110A de la figure 3, et seules les différences entre ces deux portes sont ici mises en exergue.

Plus particulièrement, la porte 110A' de la figure 5 diffère de la porte 110A de la figure 3 en ce qu'elle comprend en outre l'entrée 116, un transistor MOS 400, de préférence à canal P, et un transistor MOS 402, de préférence à canal N. Le transistor 400, respectivement 402, correspond au premier transistor, respectivement au deuxième transistor, mentionné en relation avec la figure 2, étant entendu que les termes premier et deuxième sont ici utilisés uniquement pour distinguer ces deux transistors qui auraient pu, par exemple, être également nommés troisième transistor et quatrième transistor respectivement.

Le transistor 400 a sa grille (avant) connectée à l'entrée de commande 116 de la porte. Le transistor 400 est configuré, à l'état bloqué, pour isoler électriquement la sortie 102 de la porte 110A' du noeud 301. Par exemple, le transistor 300, ou l'ensemble des transistors 300 le cas échéant, le transistor 306 et le transistor 400 sont en série entre la sortie 102 et le noeud 301. Dans l'exemple illustré par la figure 5, le transistor 400 relie le noeud 3021 à la sortie 102, le transistor 400 ayant alors une borne de conduction, par exemple sa source, reliée, de préférence connectée, au noeud 3021, et une autre borne de conduction, par exemple son drain, reliée, de préférence connectée, à la sortie 102. Dans d'autres exemples non illustrés, le transistor 400 est toujours en série avec le bloc 302, mais est disposé entre le bloc 302 et le transistor 306, ou entre le transistor 306 et le noeud 301.

Le transistor 402 a, comme le transistor 400, sa grille (avant) connectée l'entrée 116 de la porte 110A'. De manière complémentaire au transistor 400, le transistor 402 est configuré, à l'état bloqué, pour isoler électriquement la sortie 102 de la porte 110A' du noeud 304. Par exemple, le transistor 303, ou l'ensemble des transistors 303 le cas échéant, le transistor 307 et le transistor 402 sont en série entre la sortie 102 et le noeud 304. Dans l'exemple illustré par la figure 5, le transistor 402 relie le noeud 3051 à la sortie 102, le transistor 402 ayant alors une borne de conduction, par exemple sa source, reliée, de préférence connectée, au noeud 3051, et une autre borne de conduction, par exemple son drain, reliée, de préférence connectée, à la sortie 102. Dans d'autres exemples non illustrés, le transistor 402 est toujours en série avec le bloc 305, mais est disposé entre le bloc 305 et le transistor 307, ou entre le transistor 307 et le noeud 304.

Ainsi, lorsqu'un front lent descendant, respectivement montant, atteint l'entrée 100 de la porte commandable 110A', et qu'un front rapide reçu par l'entrée 100 de la porte de l'anneau qui commande la porte 110A' a déjà fait commuter l'entrée 116 de la porte 110A' à l'état haut, respectivement bas, le transistor 400, respectivement 402, est à l'état bloqué. Il en résulte que la sortie 102 de la porte 110A' est isolée du noeud 301, respectivement 304, et reste maintenue à l'état bas, respectivement haut. Le front lent se retrouve donc bloqué sur l'entrée 100 de la porte 110A' jusqu'à ce que le front rapide montant, respectivement descendant, rattrape le front lent sur l'entrée 100 de la porte.

On a décrit ci-dessus, en relation avec la figure 5, un mode de réalisation d'une porte commandable 110A' dans laquelle le ou les transistors 300, respectivement 303, sont polarisés à partir de la tension sur le noeud 120, respectivement 122, par l'intermédiaire du transistor 306, respectivement 307. Dans une variante de réalisation non illustrée, similaire à la variante de réalisation décrite en relation avec la figure 4, chaque transistor 300, respectivement 303, est mis en œuvre sur SOI ou FDSOI et comprend une grille arrière connectée au noeud 120, respectivement 122. Dans une telle variante, les transistors 306 et 307 peuvent être omis. On pourra toutefois prévoir de combiner cette variante de réalisation et le mode de réalisation de la figure 5, c'est-à-dire prévoir que la porte 110A' comprenne les transistors 306 et 307 décrits en relation avec la figure 5 et que les transistors 300 et 303 de cette porte 110A' aient leurs grilles arrière connectées aux noeuds 120 et 122 comme cela est décrit en relation avec la figure 4.

A titre d'exemple, dans le cas où :
- le comparateur 2 est identique à celui représenté en figure 2,
- les portes 110A, 110B, 110A', 110B' sont mises en œuvre de la façon décrite en relation avec les figures 3 et 5,
- chaque porte 110A, 110B, 110A', 110B' ne comprend qu'un seul transistor 300 et un seul transistor 302, et
- les portes 104 et 106 sont des portes NON-ET,
les inventeurs ont constaté un gain de consommation d'environ 30% par rapport au comparateur représenté en figure 1. En outre, lorsque le comparateur 2 selon cet exemple est mis en œuvre dans un convertisseur analogique-numérique à approximations successives, par exemple en remplacement du comparateur représenté en figure 1, cela n'a aucun impact, ou presque, sur l'erreur de conversion.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Comparateur dynamique (2) d'une première tension (V+) et d'une deuxième tension (V-), de type à poursuite de front, comprenant un anneau de portes logiques (110A, 110B, 110A', 110B', 106, 108) en série, dans lequel :
chaque porte de l'anneau comprend une première entrée (100) connectée à une sortie (102) de la porte précédente de l'anneau ;
chaque porte de l'anneau est configurée pour mettre en œuvre une fonction inverseuse entre sa première entrée (100) et sa sortie (102) ;
les portes logiques (110A, 110B, 110A', 110B', 106, 108) de l'anneau sont en nombre pair;
**caractérisé en ce que**:
au moins une (110A', 110B') desdites portes de l'anneau est commandable et est associée à une autre desdites portes de l'anneau ;
chaque porte commandable (110A', 110B') comprend une entrée de commande (116) reliée à la sortie (102) de la porte associée à ladite porte commandable ;
chaque porte commandable (110A', 110B') est configurée pour empêcher une commutation de sa sortie (102) à un état haut lorsque son entrée de commande (116) est à l'état haut, et à un état bas lorsque son entrée de commande (116) est à l'état bas ;
l'entrée de commande (116) de chaque porte commandable (110A', 110B') est configurée pour recevoir l'état de la sortie (102) de la porte associée à ladite porte commandable si un nombre pair de portes (110A, 110B, 110A', 110B', 106, 108) de l'anneau sépare la porte commandable (110A', 110B') de ladite porte associée, et pour recevoir l'état complémentaire de ladite sortie sinon.

2. Comparateur selon la revendication 1, dans lequel chaque porte commandable (110A', 110B') est séparée de la porte associée à la porte commandable par au moins une desdites portes (110A, 110B, 110A', 110B', 106, 108) de l'anneau.

3. Comparateur selon la revendication 1 ou 2, dans lequel un nombre de portes (110A, 110B, 110A', 110B', 106, 108) de l'anneau séparant chaque porte commandable (110A', 110B') de la porte associée à ladite porte commandable est strictement inférieur à la moitié du nombre total de portes de l'anneau moins un.

4. Comparateur selon l'une quelconque des revendications 1 à 3, dans lequel :
lesdites portes (110A, 110B, 110A', 110B', 106, 108) de l'anneau comprennent une première porte logique (106), une deuxième porte logique (108) et des troisièmes (110A, 110A') et quatrièmes (110B, 110B') portes logiques ;
une première branche (112) de l'anneau comprend une alternance de troisièmes (110A, 110A') et quatrièmes (110B, 110B') portes en série entre la sortie (102) de la première porte (106) et la première entrée (100) de la deuxième porte (108), la première branche (112) débutant par une troisième porte (110A) ;
une deuxième branche (114) de l'anneau comprend une alternance de troisièmes (110A, 110A') et quatrièmes (110B, 110B') portes en série entre la sortie (102) de la deuxième porte (108) et la première entrée (102) de la première porte (106), la deuxième branche (114) débutant par une quatrième porte (110B) ; et
chacune des troisièmes et quatrièmes portes (110A, 110A', 110B, 110B') est polarisée à partir de la première tension (V+) et/ou de la deuxième tension (V-), la polarisation des troisièmes portes (110A, 110A') étant complémentaire de celle des quatrièmes portes (110B, 110B'), la polarisation de chacune des troisièmes et quatrièmes portes (110A, 110A', 110B, 110B') déterminant une vitesse de commutation de la sortie (102) de ladite porte à l'état haut et une vitesse de commutation de la sortie (102) de ladite porte à l'état bas.

5. Comparateur selon la revendication 4, dans lequel chaque branche (112, 114) comporte un même nombre de troisièmes portes (110A, 110A') et chaque branche (112, 114) comporte un même nombre de quatrièmes portes (110B, 110B').

6. Comparateur selon la revendication 4 ou 5, dans lequel :
chacune des troisièmes (110A, 110A') et quatrièmes (110B, 110B') portes comprend un premier noeud de polarisation (120) et un deuxième noeud de polarisation (122), par exemple confondu avec le premier noeud, une tension (V+, V-) sur le premier noeud déterminant la vitesse de commutation de la sortie (102) de ladite porte à l'état haut et une tension (V+, V-) sur le deuxième noeud (122) déterminant la vitesse de commutation de la sortie (102) de ladite porte à l'état bas ;
les premiers noeuds (120) des troisièmes portes (110A, 110A') sont configurés pour recevoir la première tension (V+) ou la deuxième tension (V-), les premiers noeuds (120) des quatrièmes portes (110B, 110B') étant configurés pour recevoir la deuxième tension (V-) quand les premiers noeuds (120) des troisièmes portes (110A, 110A') reçoivent la première tension (V+), ou la première tension (V+) quand les premiers noeuds (120) des troisièmes portes (110A, 110A') reçoivent la deuxième tension (V-) ; et
les deuxièmes noeuds (122) des troisièmes portes (110A, 110A') sont configurés pour recevoir la première tension (V+) ou la deuxième tension (V-), les deuxièmes noeuds (122) des quatrièmes portes (110B, 110B') étant configurés pour recevoir la deuxième tension (V-) quand les deuxièmes noeuds (122) des troisièmes portes (110A, 110A') reçoivent la première tension (V+), ou la première tension (V+) quand les deuxièmes noeuds (122) des troisièmes portes (110A, 110A') reçoivent la deuxième tension (V-).

7. Comparateur selon l'une quelconque des revendications 1 à 6, dans lequel chaque porte commandable (110A', 110B') comprend :
- un premier transistor MOS (400) reliant la sortie (102) de la porte commandable (110A', 110B') à un noeud (301) d'application d'un potentiel haut (Vdd), le premier transistor (400) ayant une grille connectée à l'entrée de commande (116) de la porte commandable (110A', 110B') et étant configuré, à l'état bloqué, pour isoler électriquement la sortie (102) de la porte commandable (110A', 110B') du noeud (301) d'application du potentiel haut (Vdd) ; et
- un deuxième transistor MOS (402) reliant la sortie de la porte à un noeud (304) d'application d'un potentiel bas (GND), le deuxième transistor (402) ayant une grille connectée à l'entrée de commande (116) de la porte commandable (110A', 110B') et étant configuré, à l'état bloqué, pour isoler électriquement la sortie (102) de la porte commandable (110A', 110B') du noeud (304) d'application du potentiel bas (GND).

8. Comparateur selon la revendication 6, dans lequel chacune des troisièmes (110A, 110A') et quatrièmes (110B, 110B') portes comprend :
au moins un premier transistor MOS (300) configuré pour commuter la sortie de ladite porte à l'état haut lorsque la première entrée (100) de ladite porte reçoit un front descendant, ledit au moins un premier transistor (300) étant polarisé à partir de la tension (V+ ; V-) sur le premier noeud (120) de ladite porte ; et
au moins un deuxième transistor MOS (303) configuré pour commuter la sortie (102) de ladite porte à l'état bas lorsque la première entrée (100) de ladite porte reçoit un front montant, ledit au moins un deuxième transistor (303) étant polarisé à partir de la tension (V+ ; V-) sur le deuxième noeud (122) de ladite porte.

9. Comparateur selon la revendication 8, dans lequel chacune des troisièmes et quatrièmes portes (110A, 110A', 110B, 110B') comprend un unique premier transistor (300) et un unique deuxième transistor (303).

10. Comparateur selon la revendication 8 ou 9, dans lequel, dans chacune des troisièmes et quatrièmes portes (110A, 110A', 110B, 110B') :
ledit au moins un premier transistor (300) est en série avec un transistor (306) ayant une grille connectée au premier noeud (120) de ladite porte et ledit au moins un deuxième transistor (303) est en série avec un autre transistor (307) ayant une grille connectée au deuxième noeud (122) de ladite porte ; ou
ledit au moins un premier transistor (300) et ledit au moins un deuxième transistor (303) sont mis en œuvre sur silicium sur isolant, par exemple complétement déplété, une grille arrière de chaque premier transistor (300) étant connectée au premier noeud (120) de ladite porte et une grille arrière de chaque deuxième transistor (303) étant connectée au deuxième noeud (122) de ladite porte.

11. Comparateur selon l'une quelconque des revendication 8 à 10, dans lequel chaque porte commandable (110A', 110B') est l'une des troisièmes et quatrièmes portes (110A, 110A', 110B, 110B') et comprend en outre un troisième transistor MOS (400) configuré, à l'état bloqué, pour isoler électriquement la sortie (102) de ladite porte commandable (110A', 110B') d'un noeud (301) d'application d'une tension d'alimentation (Vcc), et un quatrième transistor MOS (402) configuré, à l'état bloqué, pour isoler électriquement la sortie (102) ladite porte commandable (110A', 110B') d'un noeud (304) d'application d'une tension de référence (GND), une grille de chacun des troisième (400) et quatrième (402) transistors étant connectée à l'entrée de commande (116) de ladite porte commandable (110A', 110B').

12. Comparateur selon l'une quelconque des revendications 5 à 11, dans lequel les première et deuxième branches (112, 114) sont symétriques.

13. Comparateur selon l'une quelconque des revendications 5 à 12, dans lequel chacune des première (106) et deuxième (108) portes comprend en outre une deuxième entrée (118) configurée pour recevoir un signal de synchronisation (clk), la mise en œuvre de la fonction inverseuse entre la première entrée (100) et la sortie (102) de ladite porte étant conditionnée par l'état du signal de synchronisation (clk).

14. Comparateur selon l'une quelconque des revendications 5 à 13, dans lequel, pour chaque porte commandable (110A', 110B'), la porte associée à ladite porte commandable est la première porte (106) ou l'une des troisièmes et quatrièmes portes (110A, 110B) de la première branche (112) lorsque ladite porte commandable (110B') appartient à la première branche (112), et est la deuxième porte (108) ou l'une des troisièmes et quatrièmes portes (110A, 110B) de la deuxième branche (114) lorsque ladite porte commandable (110A') appartient à la deuxième branche (114).

15. Convertisseur analogique-numérique comprenant un comparateur selon l'une quelconque des revendications 1 à 14.

## Patentansprüche

1. Dynamischer Komparator (2) einer ersten Spannung (V+) mit einer zweiten Spannung (V-), vom Flankenverfolgungstyp, aufweisend einen Ring von Logikgattern (110A, 110B, 110A', 110B', 106, 108) in Reihe, wobei:
jedes Gatter des Rings einen ersten Eingang (100) aufweist, der mit einem Ausgang (102) des vorangehenden Gatters des Rings verbunden ist;
jedes Gatter des Rings so konfiguriert ist, dass es eine invertierende Funktion zwischen seinem ersten Eingang (100) und seinem Ausgang (102) ausführt;
die logischen Gatter (110A, 110B, 110A', 110B', 106, 108) des Rings in gerader Anzahl vorhanden sind;
**dadurch gekennzeichnet, dass**:
mindestens eines (110A', 110B') der Gatter des Rings steuerbar ist und mit einem anderen der Gatter des Rings assoziiert ist;
jedes steuerbare Gatter (110A', 110B') einen Steuereingang (116) aufweist, der mit dem Ausgang (102) des mit dem steuerbaren Gatter assoziierten Gatters gekoppelt ist;
jedes steuerbare Gatter (110A', 110B') so konfiguriert ist, dass es das Schalten seines Ausgangs (102) in einen hohen Zustand verhindert, wenn sein Steuereingang (116) im hohen Zustand ist, und in einen niedrigen Zustand, wenn sein Steuereingang (116) im niedrigen Zustand ist;
der Steuereingang (116) jedes steuerbaren Gatters (110A', 110B') so konfiguriert ist, dass er den Zustand des Ausgangs (102) des mit dem steuerbaren Gatter assoziierten Gatters empfängt, wenn eine gerade Anzahl von Gattern (110A, 110B, 110A', 110B', 106, 108) des Rings das steuerbare Gatter (110A', 110B') von dem assoziierten Gatter trennt, und dass er andernfalls den komplementären Zustand des Ausgangs empfängt.

2. Komparator nach Anspruch 1, wobei jedes steuerbare Gatter (110A', 110B') von dem mit dem steuerbaren Gatter assoziierten Gatter durch mindestens eines der Gatter (110A, 110B, 110A', 110B', 106, 108) des Rings getrennt ist.

3. Komparator nach Anspruch 1 oder 2, wobei eine Anzahl von Gattern (110A, 110B, 110A', 110B', 106, 108) des Rings, die jedes steuerbare Gatter (110A', 110B') von dem mit dem steuerbaren Gatter assoziierten Gatter trennt, strikt weniger als die Hälfte der Gesamtzahl der Gatter des Rings minus eins beträgt.

4. Der Komparator nach einem der Ansprüche 1 bis 3, wobei:
die Gatter (110A, 110B, 110A', 110B', 106, 108) des Rings ein erstes logisches Gatter (106), ein zweites logisches Gatter (108) und dritte (110A, 110A') und vierte (110B, 110B') logisches Gatter aufweisen;
ein erster Zweig (112) des Rings abwechselnd dritte (110A, 110A') und vierte (110B, 110B') Gatter in Reihe zwischen dem Ausgang (102) des ersten Gatters (106) und dem ersten Eingang (100) des zweiten Gatters (108) aufweist, wobei der erste Zweig (112) mit einem dritten Gatter (110A) beginnt;
ein zweiter Zweig (114) des Rings abwechselnd dritte (110A, 110A') und vierte (110B, 110B') Gatter in Reihe zwischen dem Ausgang (102) des zweiten (108) Gatters und dem ersten Eingang (102) des ersten Gatters (106) aufweist, wobei der zweite Zweig (114) mit einem vierten Gatter (110B) beginnt; und
jedes der dritten und vierten Gatter (110A, 110A', 110B, 110B') von der ersten Spannung (V+) und/oder von der zweiten Spannung (V-) polarisiert ist, wobei die Polarisation der dritten Gatter (110A, 110A') komplementär zu derjenigen der vierten Gatter (110B, 110B') ist, wobei die Polarisierung jedes der dritten und vierten Gatter (110A, 110A', 110B, 110B') eine Schaltgeschwindigkeit des Ausgangs (102) des Gatters in den hohen Zustand und eine Schaltgeschwindigkeit des Ausgangs (102) des Gatters in den niedrigen Zustand bestimmt.

5. Komparator nach Anspruch 4, wobei jeder Zweig (112, 114) eine gleiche Anzahl von dritten Gattern (110A, 110A') und jeder Zweig (112, 114) eine gleiche Anzahl von vierten Gattern (110B, 110B') aufweist.

6. Der Komparator nach Anspruch 4 oder 5, wobei:
jedes der dritten (110A, 110A') und vierten (110B, 110B') Gatter einen ersten Polarisationsknoten (120) und einen zweiten Polarisationsknoten (122) aufweist, beispielsweise in Kombination mit dem ersten Knoten, wobei eine Spannung (V+, V-) am ersten Knoten die Schaltgeschwindigkeit des Ausgangs (102) des Gatters in den hohen Zustand und eine Spannung (V+, V-) am zweiten Knoten (122) die Schaltgeschwindigkeit des Ausgangs (102) des Gatters in den niedrigen Zustand bestimmt;
die ersten Knoten (120) der dritten Gatter (110A, 110A') konfiguriert sind, um die erste Spannung (V+) oder die zweite Spannung (V-) zu empfangen, wobei die ersten Knoten (120) der vierten Gatter (110B, 110B') so konfiguriert sind, dass sie die zweite Spannung (V-) empfangen, wenn die ersten Knoten (120) der dritten Gatter (110A, 110A') die erste Spannung (V+) empfangen, oder die erste Spannung (V+), wenn die ersten Knoten (120) der dritten Gatter (110A, 110A') die zweite Spannung (V-) empfangen; und
die zweiten Knoten (122) der dritten Gatter (110A, 110A') konfiguriert sind, um die erste Spannung (V+) oder die zweite Spannung (V-) zu empfangen, wobei die zweiten Knoten (122) der vierten Gatter (110B, 110B') so konfiguriert sind, dass sie die zweite Spannung (V-) empfangen, wenn die zweiten Knotenpunkte (122) der dritten Gatter (110A, 110A') die erste Spannung (V+) empfangen, oder die erste Spannung (V+), wenn die zweiten Knotenpunkte (122) der dritten Gatter (110A, 110A') die zweite Spannung (V-) empfangen.

7. Der Komparator nach einem der Ansprüche 1 bis 6, wobei jedes steuerbare Gatter (110A', 110B') Folgendes aufweist:
- einen ersten MOS-Transistor (400), der den Ausgang (102) des steuerbaren Gatters (110A', 110B') mit einem Knoten (301) zum Anlegen eines hohen Potentials (Vdd) verbindet, wobei der erste Transistor (400) ein Gate aufweist, das mit dem Steuereingang (116) des steuerbaren Gatters (110A', 110B') verbunden ist und im ausgeschalteten Zustand so konfiguriert ist, dass es den Ausgang (102) des steuerbaren Gatters (110A', 110B') von dem Knoten (301) zum Anlegen des hohen Potentials (Vdd) elektrisch isoliert; und
- einen zweiten MOS-Transistor (402), der den Ausgang des Gatters mit einem Knoten (304) zum Anlegen eines niedrigen Potentials (GND) verbindet, wobei der zweite Transistor (402) ein Gate aufweist, das mit dem Steuereingang (116) des steuerbaren Gatters (110A', 110B') verbunden ist und so konfiguriert ist, dass es im Aus-Zustand den Ausgang (102) des steuerbaren Gatters (110A', 110B') von dem Knoten (304) zum Anlegen des niedrigen Potentials (GND) elektrisch isoliert.

8. Komparator nach Anspruch 6, wobei jedes der dritten (110A, 110A') und vierten (110B, 110B') Gatter Folgendes aufweist:
mindestens einen ersten MOS-Transistor (300), der so konfiguriert ist, dass er den Ausgang des Gatters in den hohen Zustand schaltet, wenn der erste Eingang (100) des Gatters eine fallende Flanke empfängt, wobei der mindestens eine erste Transistor (300) von der Spannung (V+; V-) am ersten Knoten (120) des Gatters polarisiert wird; und
mindestens einen zweiten MOS-Transistor (303), der so konfiguriert ist, dass er den Ausgang (102) des Gatters in den niedrigen Zustand schaltet, wenn der erste Eingang (100) des Gatters eine steigende Flanke empfängt, wobei der mindestens eine zweite Transistor (303) von der Spannung (V+; V-) am zweiten Knoten (122) des Gatters polarisiert wird.

9. Komparator nach Anspruch 8, wobei jedes der dritten und vierten Gatter (110A, 110A', 110B, 110B') einen einzelnen ersten Transistor (300) und einen einzelnen zweiten Transistor (303) aufweist.

10. Komparator nach Anspruch 8 oder 9, wobei in jedem der dritten und vierten Gatter (110A, 110A', 110B, 110B'):
der mindestens eine erste Transistor (300) in Reihe mit einem Transistor (306) liegt, dessen Gate mit dem ersten Knoten (120) des Gatters verbunden ist, und der mindestens eine zweite Transistor (303) in Reihe mit einem anderen Transistor (307) liegt, dessen Gate mit dem zweiten Knoten (122) des Gatters verbunden ist; oder
der mindestens eine erste Transistor (300) und der mindestens eine zweite Transistor (303) als Silizium auf Isolator implementiert sind, beispielsweise vollständig verarmt, wobei ein Back-Gate jedes ersten Transistors (300) mit dem ersten Knoten (120) des Gatters verbunden ist und ein Back-Gate jedes zweiten Transistors (303) mit dem zweiten Knoten (122) des Gatters verbunden ist.

11. Komparator nach einem der Ansprüche 8 bis 10, wobei jedes steuerbare Gatter (110A', 110B') eines der dritten und vierten Gatter (110A, 110A', 110B, 110B') ist und ferner einen dritten MOS-Transistor (400) aufweist, der so konfiguriert ist, dass er im ausgeschalteten Zustand den Ausgang (102) des steuerbaren Gatters (110A', 110B') von einem Knoten (301) zum Anlegen einer Versorgungsspannung (Vcc) elektrisch isoliert, und einen vierten MOS-Transistor (402), der so konfiguriert ist, dass er im ausgeschalteten Zustand den Ausgang (102) des steuerbaren Gatters (110A', 110B') von einem Knoten (304) zum Anlegen einer Referenzspannung (GND) elektrisch isoliert, wobei ein Gate des dritten (400) und des vierten (402) Transistors jeweils mit dem Steuereingang (116) des steuerbaren Gatters (110A', 110B') verbunden ist.

12. Der Komparator nach einem der Ansprüche 5 bis 11, wobei der erste und der zweite Zweig (112, 114) symmetrisch sind.

13. Komparator nach einem der Ansprüche 5 bis 12, wobei jedes der ersten (106) und zweiten (108) Gatter ferner einen zweiten Eingang (118) aufweist, der so konfiguriert ist, dass er ein Synchronisationssignal (clk) empfängt, wobei die Implementierung der invertierenden Funktion zwischen dem ersten Eingang (100) und dem Ausgang (102) des Gatters durch den Zustand des Synchronisationssignals (clk) bedingt ist.

14. Komparator nach einem der Ansprüche 5 bis 13, wobei für jedes steuerbare Gatter (110A', 110B') das mit dem steuerbaren Gatter assoziierte Gatter das erste Gatter (106) oder eines der dritten und vierten Gatter (110A, 110B) des ersten Zweigs (112) ist, wenn das steuerbare Gatter (110B') zu dem ersten Zweig (112) gehört, und das zweite Gatter (108) oder eines der dritten und vierten Gatter (110A, 110B) des zweiten Zweigs (114) ist, wenn das steuerbare Gatter (110A') zu dem zweiten Zweig (114) gehört.

15. Analog-Digital-Wandler mit einem Komparator nach einem der Ansprüche 1 bis 14.

## Claims

1. A dynamic comparator (2) of a first voltage (V+) with a second voltage (V-), of the edge pursuit type, comprising a ring of logic gates (110A, 110B, 110A', 110B', 106, 108) in series, wherein:
each gate of the ring comprises a first input (100) connected to an output (102) of the preceding gate of the ring;
each gate of the ring is configured to implement an inverting function between its first input (100) and its output (102);
the logic gates (110A, 110B, 110A', 110B', 106, 108) of the ring are even in number;
**characterized in that**:
at least one (110A', 110B') of said gates of the ring is controllable and is associated with another one of said gates of the ring;
each controllable gate (110A', 110B') comprises a control input (116) coupled to the output (102) of the gate associated with said controllable gate;
each controllable gate (110A', 110B') is configured to prevent switching of its output (102) to a high state when its control input (116) is in the high state, and to a low state when its control input (116) is in the low state;
the control input (116) of each controllable gate (110A', 110B') is configured to receive the state of the output (102) of the gate associated with said controllable gate if an even number of gates (110A, 110B, 110A', 110B', 106, 108) of the ring separates the controllable gate (110A', 110B') from said associated gate, and to receive the complementary state of said output if not.

2. The comparator according to claim 1, wherein each controllable gate (110A', 110B') is separated from the gate associated with the controllable gate by at least one of said gates (110A, 110B, 110A', 110B', 106, 108) of the ring.

3. The comparator according to claim 1 or 2, wherein a number of gates (110A, 110B, 110A', 110B', 106, 108) of the ring separating each controllable gate (110A', 110B') from the gate associated with said controllable gate is strictly less than half the total number of gates of the ring minus one.

4. The comparator according to any one of claims 1 to 3, wherein:
said gates (110A, 110B, 110A', 110B', 106, 108) of the ring comprise a first logic gate (106), a second logic gate (108), and third (110A, 110A') and fourth (110B, 110B') logic gates;
a first branch (112) of the ring comprises alternating third (110A, 110A') and fourth (110B, 110B') gates in series between the output (102) of the first gate (106) and the first input (100) of the second gate (108), the first branch (112) beginning with a third gate (110A);
a second branch (114) of the ring comprises alternating third (110A, 110A') and fourth (110B, 110B') gates in series between the output (102) of the second (108) gate and the first input (102) of the first gate (106), the second branch (114) beginning with a fourth gate (110B); and
each of the third and fourth gates (110A, 110A', 110B, 110B') is polarized from the first voltage (V+) and/or from the second voltage (V-), the polarization of the third gates (110A, 110A') being complementary to that of the fourth gates (110B, 110B'), the polarization of each of the third and fourth gates (110A, 110A', 110B, 110B') determining a switching speed of the output (102) of said gate to the high state and a switching speed of the output (102) of said gate to the low state.

5. The comparator according to claim 4, wherein each branch (112, 114) includes a same number of third gates (110A, 110A') and each branch (112, 114) includes a same number of fourth gates (110B, 110B').

6. The comparator according to claim 4 or 5, wherein:
each of the third (110A, 110A') and fourth (110B, 110B') gates comprises a first polarization node (120) and a second polarization node (122), for example combined with the first node, a voltage (V+, V-) on the first node determining the switching speed of the output (102) of said gate to the high state and a voltage (V+, V-) on the second node (122) determining the switching speed of the output (102) of said gate to the low state;
the first nodes (120) of the third gates (110A, 110A') are configured to receive the first voltage (V+) or the second voltage (V-), the first nodes (120) of the fourth gates (110B, 110B') being configured to receive the second voltage (V-) when the first nodes (120) of the third gates (110A, 110A') receive the first voltage (V+), or the first voltage (V+) when the first nodes (120) of the third gates (110A, 110A') receive the second voltage (V-); and
the second nodes (122) of the third gates (110A, 110A') are configured to receive the first voltage (V+) or the second voltage (V-), the second nodes (122) of the fourth gates (110B, 110B') being configured to receive the second voltage (V-) when the second nodes (122) of the third gates (110A, 110A') receive the first voltage (V+), or the first voltage (V+) when the second nodes (122) of the third gates (110A, 110A') receive the second voltage (V-).

7. The comparator according to any one of claims 1 to 6, wherein each controllable gate (110A', 110B') comprises:
- a first MOS transistor (400) connecting the output (102) of the controllable gate (110A', 110B') to a node (301) for applying a high potential (Vdd), the first transistor (400) having a gate connected to the control input (116) of the controllable gate (110A', 110B') and being configured, in the off state, to electrically isolate the output (102) of the controllable gate (110A', 110B') from the node (301) for applying the high potential (Vdd); and
- a second MOS transistor (402) connecting the output of the gate to a node (304) for applying a low potential (GND), the second transistor (402) having a gate connected to the control input (116) of the controllable gate (110A', 110B') and being configured, in the off state, to electrically isolate the output (102) of the controllable gate (110A', 110B') from the node (304) for applying the low potential (GND).

8. The comparator according to claim 6 wherein each of the third (110A, 110A') and fourth (110B, 110B') gates comprises:
at least one first MOS transistor (300) configured to switch the output of said gate to the high state when the first input (100) of said gate receives a falling edge, said at least one first transistor (300) being polarized from the voltage (V+; V-) on the first node (120) of said gate; and
at least one second MOS transistor (303) configured to switch the output (102) of said gate to the low state when the first input (100) of said gate receives a rising edge, said at least one second transistor (303) being polarized from the voltage (V+; V-) on the second node (122) of said gate.

9. The comparator according to claim 8, wherein each of the third and fourth gates (110A, 110A', 110B, 110B') comprises a single first transistor (300) and a single second transistor (303).

10. The comparator according to claim 8 or 9, wherein, in each of the third and fourth gates (110A, 110A', 110B, 110B'):
said at least one first transistor (300) is in series with a transistor (306) having a gate connected to the first node (120) of said gate and said at least one second transistor (303) is in series with another transistor (307) having a gate connected to the second node (122) of said gate; or
said at least one first transistor (300) and said at least one second transistor (303) are implemented on silicon on insulator, for example completely depleted, a back gate of each first transistor (300) being connected to the first node (120) of said gate and a back gate of each second transistor (303) being connected to the second node (122) of said gate.

11. The comparator according to any one of claims 8 to 10, wherein each controllable gate (110A', 110B') is one of the third and fourth gates (110A, 110A', 110B, 110B') and further comprises a third MOS transistor (400) configured, in the off state, to electrically isolate the output (102) of said controllable gate (110A', 110B') from a node (301) for applying a supply voltage (Vcc), and a fourth MOS transistor (402) configured, in the off state, to electrically isolate the output (102) of said controllable gate (110A', 110B') from a node (304) for applying a reference voltage (GND), a gate of each of the third (400) and fourth (402) transistors being connected to the control input (116) of said controllable gate (110A', 110B').

12. The comparator according to any one of claims 5 to 11, wherein the first and second branches (112, 114) are symmetrical.

13. The comparator according to any one of claims 5 to 12, wherein each of the first (106) and second (108) gates further comprises a second input (118) configured to receive a synchronization signal (clk), the implementation of the inverting function between the first input (100) and the output (102) of said gate being conditioned by the state of the synchronization signal (clk).

14. The comparator according to any one of claims 5 to 13, wherein, for each controllable gate (110A', 110B'), the gate associated with said controllable gate is the first gate (106) or one of the third and fourth gates (110A, 110B) of the first branch (112) when said controllable gate (110B') belongs to the first branch (112), and is the second gate (108) or one of the third and fourth gates (110A, 110B) of the second branch (114) when said controllable gate (110A') belongs to the second branch (114).

15. An analog-digital converter comprising a comparator according to any one of claims 1 to 14.
